# EUROPEAN PATENT SPECIFICATION

(11) **EP 1 427 962 B1**
(45) Date of publication and mention of the grant of the patent: **10.01.2007**
(21) Application number: 02766298.0
(22) Date of filing: 17.09.2002
(51) Int. Cl.: F21V 19/02, F21V 14/06

(54) **VARIABLE OPTICS SPOT MODULE**
EINSTELLBARE OPTIK FÜR SPOT MODUL
MODULE DE PROJECTEUR A DISPOSITIFS OPTIQUES VARIABLES

(30) Priority: 17.09.2001 US 682535; 21.12.2001 US 683395
(43) Date of publication of application: 16.06.2004
(73) Proprietor: Gelcore LLC, Valley View, OH 44125-4635 (US)
(72) Inventor: SOMMERS, Mathew, Sagamore Hills, OH 44067 (US); PETROSKI, James, T., Parma, OH 44134 (US)
(74) Representative: Alcock, David
(86) International application number: PCT/US2002/029561
(87) International publication number: WO 2003/025458

(56) References cited:
- EP-A- 1 072 884
- US-A- 5 580 163
- US-A- 6 033 087

## Description

### BACKGROUND OF THE INVENTION

### FIELD OF THE INVENTION

The invention relates to the lighting arts. It is especially applicable to the packaging of light emitting diodes (LED's) to form a spot light, flashlight, or other lamp type that produces a collimated or partially collimated beam, and will be described with particular reference thereto. However, the invention will also find application in packaging of LED's, semiconductor lasers, halogen bulbs, and other light emitting elements for spot lighting, flood lighting, and other optical applications.

### DISCUSSION OF THE ART

Spot light lamps emit a collimated or partially collimated beam of light (e.g., a conical beam), and are employed in room lighting, hand-held flash lights, theater spot lighting, and other applications. Examples of such lamps include the MR-series halogen spot lights which incorporate an essentially nondirectional halogen light bulb arranged within a directional reflector, such as a parabolic reflector. The MR-series halogen spot lights are commercially available with or without a front lens, and typically include electrical connectors disposed behind the parabolic reflector, i.e. outside of the range of the directed beam. The reflector, optionally in cooperation with a front lens, effectuates collimation of the halogen light bulb output to produce the collimated or conical light beam. The MR-series spot lights are available in a range of sizes, wattages, color temperatures, and beam angles. However, the MR-series spot lights do not include adjustable beams.

The Maglite® flashlight is a prior art device that has an adjustable spot beam. An incandescent light bulb is arranged inside an essentially parabolic reflector. This device effectuates a variable beam angle ranging from a narrow spot beam to a wide, "flood" beam, by including a rotating actuator for moving the reflector axially with respect to the incandescent bulb. This arrangement suffers from significant beam non-uniformity when the light source is strongly defocused. Under conditions of extreme defocusing, the Maglite® flashlight beam exhibits a black spot at the beam's center.

Lamps which utilize one or more LED's as the source of light are becoming more attractive as the light output intensities of commercial LED's steadily increase over time due to design, materials, and manufacturing improvements. Advantageously for spot module applications, commercial LED's typically have a lensing effect produced by the epoxy encapsulant that is usually employed to seal the LED chip from the environment. Hence, these commercial LED's are already somewhat directional, and this directionality can be enhanced using an external lens. Additionally, LED's that emit white light of reasonably high spectral quality are now available. In spite of continuing improvements in LED light output, at present an individual LED is typically insufficiently bright for most lighting applications. Nonetheless, due to the small size of LED's, this intensity limitation can be obviated through the use of a plurality of closely packed LED's that cooperate to produce sufficient light.

Application of LED's to spot lighting applications, and especially to spot lighting applications in which the LED-based lamp is contemplated as a retrofit for replacing an existing lamp that employs another lighting technology (e.g., a retrofit for replacing an MR-series halogen lamp) is complicated by the use of multiple LED's as the light source. The spatially distributed nature of an LED source array greatly reduces the effectiveness of conventional parabolic reflectors which are designed to collimate and direct light emanating from a point source, such as light generated by a halogen or incandescent bulb filament. Furthermore, a front lens of the type optionally included in an MR-series halogen spot lamp is ill-suited for collimating light from a plurality of LED's, because most of the LED's are not positioned on the optical axis of the lens. Thus, the optical systems of existing spot lamps, both with and without variable beam angle, are relatively ineffective when used in conjunction with LED light sources.

EP 1072884 discloses discloses a single housing which contains both a lens seat and also a further seat for the LEDs. EP 1072884 also discloses that this arrangement may incorporate a threaded fitting for adjusting LED/lens separation.

The present invention contemplates an improved light source lamp that overcomes the above-mentioned limitations and others.

### BRIEF SUMMARY OF THE INVENTION

In accordance with one embodiment of the present invention there is provided a spot module having a selectable light output, the spot module including:a substrate **(14, 34, 112, 142, 152);** a plurality of optical sources **(114A, 114B, 114C, 114D)** arranged on the substrate **(14**, **34, 112, 142, 152),** each optical source **(114A, 114B, 114C, 114D)** including: at least one light emitting diode **(116A, 116B, 116C, 116D, 146A, 146B, 146C, 146D, 156A, 156B),** and at least one optical element **(18, 38)** in operative communication with the at least one light emitting diode **(116A, 116B, 116C, 116D, 146A, 146B, 146C, 146D, 156A, 156B);** and a zoom apparatus comprising: inner and outer slidably interconnected sleeves **(42, 44),** one of the sleeves **(42, 44)** being connected with the at least one light emitting diode **(116A, 116B, 116C, 116D, 146A, 146B, 146C, 146D, 156A, 156B)** and the other one of the sleeves **(42, 44)** being connected with the at least one optical element **(18, 38),** relative sliding of the inner and outer slidably interconnected sleeves **(42, 44)** adjusting an axial separation between the at least one light emitting diode **(116A, 116B, 116C, 116D, 146A, 146B, 146C, 146D, 156A, 156B)** of each optical source **(114A, 114B, 114C, 114D)** and its corresponding at least one optical element **(18, 38).**

In accordance with another embodiment of the present invention there is provided a lamp including: an LED module **(86)** including a plurality of LEDs **(82);** an optical system comprising a plurality of lenses **(88)** in optical communication with the LED module **(86)** along an optical axis between the lenses and the LEDs; and a zoom apparatus **(90)** that selectively adjusts the relative axial separation of the optical system and the LED module **(86),** the zoom apparatus including: a first sleeve **(92)** having the LED module **(86)** arranged thereon, the first sleeve **(90)** further having a first threading **(96)** arranged thereon, a second sleeve **(94)** having a second threading **(98)** arranged thereon that is adapted to cooperate with the first threading **(96)** such that the first sleeve **(92)** and the second sleeve **(94)** are relatively movable in a screwing fashion, the second sleeve **(94)** further having the optical system arranged thereon, and an index system that relatively biases the first sleeve **(92)** and the second sleeve **(94)** into one or more selectable relative rotational orientations.

### BRIEF DESCRIPTION OF THE DRAWINGS

The invention may take form in various components and arrangements of components, and in various steps and arrangements of steps. The drawings are only for purposes of illustrating a preferred embodiment and are not to be construed as limiting the invention.
FIGURE **1** shows an isometric view of a zoomable spot lamp that suitably practices an embodiment of the invention.
FIGURE **2** shows a schematic cross-sectional view of a zoomable spot lamp that suitably practices an embodiment of the invention, the lamp being shown as adjusted to produce a wide-angle flood beam.
FIGURE **3** shows a schematic cross-sectional view of the lamp of FIGURE **2,** adjusted to produce a narrow-angle spot beam.
FIGURE **4** shows a front view of the lamp of FIGURE **2,** looking directly into the beam, with dotted lines indicating the hidden sleeves of the zoom apparatus and the interlocking mechanism.
FIGURE **5** shows a schematic cross-sectional view of the lamp of FIGURE **2** in a first mounting configuration.
**FIGURE 6** shows a schematic cross-sectional view of the lamp of FIGURE **2** in a second mounting configuration.
FIGURE **7** shows a schematic cross-sectional view of a zoomable spot lamp that suitably practices another embodiment of the invention, the lamp being shown as adjusted to produce a wide-angle flood beam.
FIGURE **8A** shows a front view of the lamp of FIGURE **7,** looking directly into the beam, with the zoom apparatus rotated at a reference position, herein designated as 0°, between the first and second sleeves.
FIGURE **8B** shows a front view of the lamp of FIGURE **7,** looking directly into the beam, with the second sleeve rotated 120° compared with its reference orientation of FIGURE **8A.**
FIGURE 8C shows a front view of the lamp of FIGURE **7,** looking directly into the beam, with the second sleeve rotated 240° compared with its reference orientation of FIGURE **8A.**
FIGURE **8D** shows a front view of the lamp of FIGURE **7,** looking directly into the beam, with the second sleeve rotated slightly more than 240° compared with its reference orientation of FIGURE **8A.**
FIGURE **9** shows a perspective view of another lamp or light source which suitably practices an embodiment of the invention;
FIGURE **10** shows a cross-sectional view of the lamp or light source of FIGURE **9** taken perpendicular to the substrate along the Line **L-L** shown in FIGURE **9;**
FIGURE **11** shows an schematic representation of the electrical configuration of the lamp or light source of FIGURES **9** and **10;**
FIGURE **12** shows a perspective view of a lamp or light source which suitably practices another embodiment of the invention; and
FIGURE **13** shows a perspective view of a lamp or light source which suitably practices yet another embodiment of the invention.

### DETAILED DESCRIPTION OF THE INVENTION

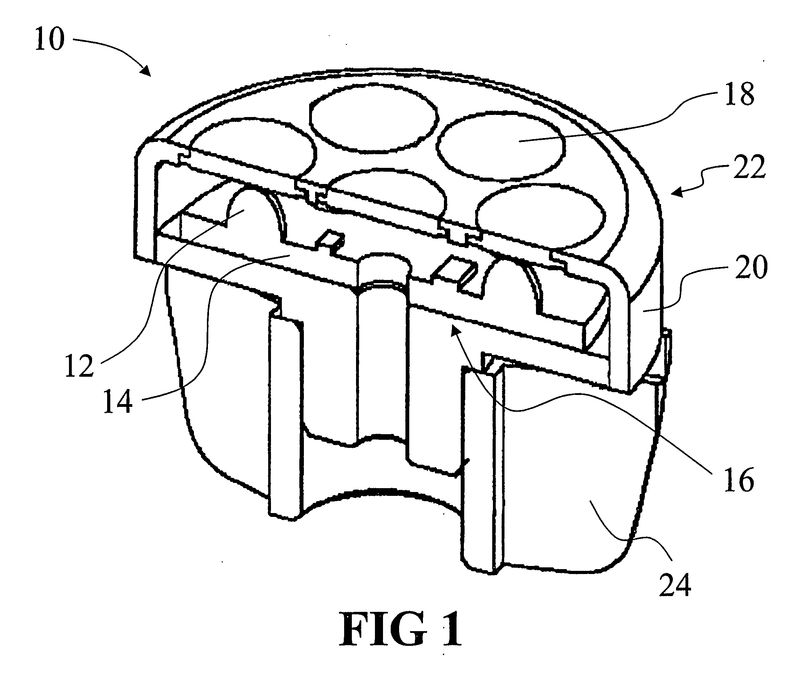

With reference to FIGURE **1,** a lamp that suitably practices an embodiment of the invention is described. A lamp or light source **10** includes a plurality of light emitting diodes (LED's) **12** arranged on a base or substrate **14,** the combination of which forms an LED module **16.** A plurality of lenses **18** are arranged in conjunction with the LED's **12,** such that each LED **12** lies on the optical axis of one of the lenses **18.** The lenses **18** effectuate a collimation of the light emitted by the LED's **12,** so that the lamp output is a collimated or conical beam having a desired angle of divergence. Preferably, the LED's **12** are positioned closely to the lenses **18** to maximize the light captured. For this reason, the lenses **18** should be fast lenses, i.e., should have a low f number. These preferred lens optical properties are not readily obtainable using conventional lenses. Accordingly, fresnel lenses are advantageously used for the lenses **18** to provide very low f number behavior in a reasonably sized lens.

In the illustrated embodiment of FIGURE **1,** there is a one-to-one correspondence between lenses **18** and LED's **12.** That is, each LED **12** is associated with a single lens **18.** This in turn allows each LED **12** to lie on the optical axis of its corresponding lens **18,** which maximizes the optical efficiency of the combination. In other words, the spatial pattern of the lenses **18** corresponds with the spatial pattern of the LED's **12.**

The lenses **18** are arranged on a zoom apparatus **20** which together with the lenses form an adaptive optical system **22.** The optical system **22** is relatively adjustable with respect the LED module **16** to enable a selectable distance separation along the optical axis between the lenses **18** and the LED's **12.**

Because the lamp **10** is intended for lighting applications, the LED's **12** preferably emit light at high intensities. This entails electrically driving the LED's **12** at relatively high currents, e.g., as high as a few hundred milliamperes per LED **12.** Because LED light emission is very temperature-sensitive, the heat dissipated in the LED's **12** as a consequence of the high driving currents is advantageously removed by a heat sink **24** which is thermally connected with the substrate **14.**

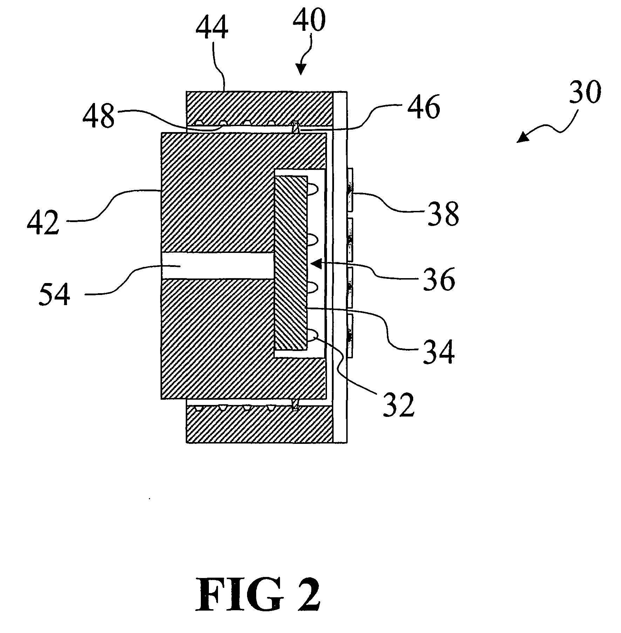

With reference now to FIGURES **2** through **4,** a lamp **30** that suitably practices an embodiment of the invention in which the zoom apparatus operates on a mechanical sliding principle is described. LED's **32** are arranged on a substrate **34** forming an LED module **36.** A plurality of lenses **38,** which are preferably Fresnel lenses, are arranged in correspondence with the LED's **32,** with each LED **32** lying on the optical axis of an associated lens **38.** A sliding zoom apparatus **40** includes two slidably interconnecting elements or sleeves **42, 44.** The LED module **36** is arranged on or in the first sleeve **42** in a fixed manner. The lenses **38** are arranged on or in the second sleeve **44,** also in a fixed manner. It will be appreciated that zoom apparatus **40** of the lamp **30** effectuates beam width adjustment through the relative motion of the sleeves **42,44.**

The configuration of the zoom apparatus **40** shown in FIGURE **2** corresponds to a minimum relative separation between the LED's **32** and the lenses **38.** This configuration produces a wide beam, i.e., a conical beam with a wide angle of divergence, sometimes called a flood light.

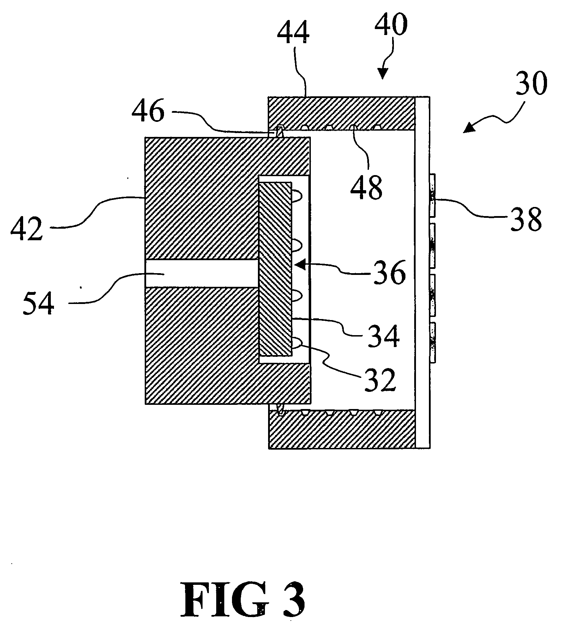

The configuration of the zoom apparatus **40** shown in FIGURE **3** corresponds to a maximum relative separation between the LED's **32** and the lenses **38**. This configuration produces a narrow beam, i.e., a conical beam with a small angle of divergence, sometimes called a spot light.

A sliding zoom apparatus can optionally effectuate continuous zoom adjustment (not shown). For continuous zoom adjustment, the sleeves should be of sufficiently close relative tolerances so that the frictional force between the two sleeves **42, 44** inhibits unintended sliding slippage therebetween.

Alternatively, as shown in the illustrated embodiment of FIGURES **2** and **3,** the zoom apparatus **40** is an indexed zoom apparatus. A projection or stop **46,** which can be a single projection, a plurality of projections, or an annular projection, extends from the first sleeve **42** and is selectably moved into one of five recesses or stop positions **48,** which can be annular grooves, holes, or the like. The projection(s) **46** and the recesses **48** are mutually adapted to enable relative movement of the sleeves **42, 44** to selectably move the stop **46** to a selected stop position **48.** The projections or stop **46** and the recesses or stop positions **48** cooperate to bias the zoom apparatus into certain pre-selected axial spacings or stop positions. It will be appreciated that such an index system tends to reduce slippage between the two sleeves **42, 44** versus a similar continuous zoom adjustment which relies upon frictional force to prevent slippage. Of course, the index system of FIGURES **2** and **3** is exemplary only, and many variations thereof are contemplated, such as placing the stop onto the first sleeve and the recesses onto the second sleeve, using other than five stop positions, etc.

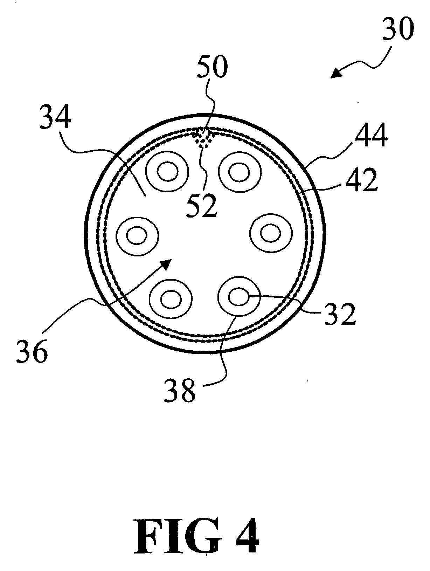

With reference to FIGURE **4,** in addition to the zoom indexing system exemplarily effectuated by projection(s) **46** and recesses **48,** the lamp **30** also includes an advantageous interlocking mechanism including a linear projection **50** aligned along the sliding direction of the sliding zoom apparatus **40** and extending inwardly from the second sleeve **44** toward the first sleeve **42,** and a corresponding linear depression **52** that receives the linear projection **50.** This interlocking mechanism prevents relative rotation between the first and second sleeves **42, 44** so that the LED's **32** are maintained centered on the optical axes of the lenses **38.**

With reference to FIGURES **2** and **3,** the lamp **30** also includes one or more electrical conduits **54** through which wires or other electrical conductors (not shown) connect the LED's to an associated power supply (not shown). Although an exemplary single conduit **54** is shown, numerous variations are contemplated, such as separate conduits for each LED **32.**

In addition, electrical components such as a printed circuit board that electrically connects the LED's **32** and has optional driving electronics operatively arranged thereupon, metallized connections, an associated battery or other electrical power supply, etc. are also contemplated (components not shown). It will be recognized that such electrical components are well known to those skilled in the art.

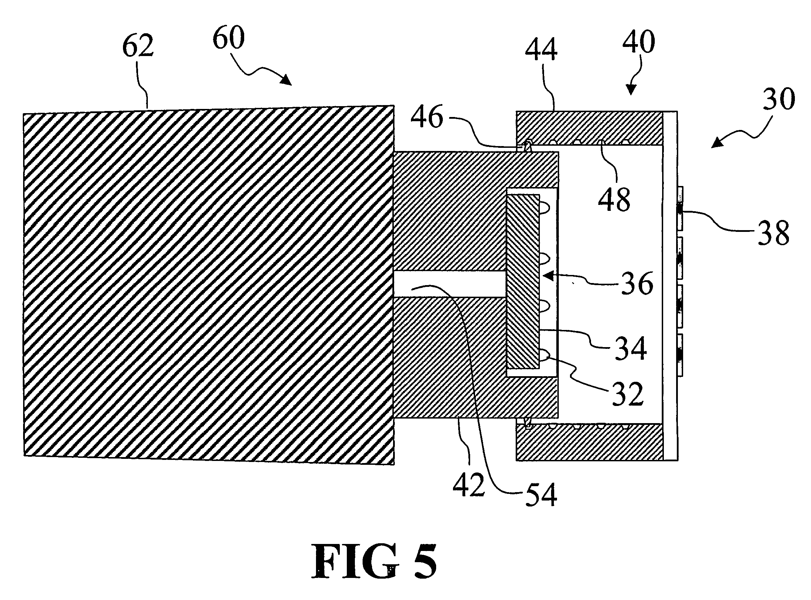

With reference to FIGURE **5,** a mounting configuration **60** for the lamp **30** of FIGURES **2** through **4** is described. In the mounting configuration **60,** the inner sleeve **42** remains fixed relative to a mounting element **62,** while the sliding movement of the outer sleeve **44** effectuates the zoom adjustment. The mounting element **62** could, for example, be the approximately cylindrical body of a hand flashlight that contains associated batteries to power the lamp **30,** in which case movement of the outer sleeve **44** is effectuated manually by the user. Alternatively, for a theater stage spotlight mounting configuration, the movement of sleeve **44** could be mechanized. It will be appreciated that the mounting configuration **60** is rather simple to construct because the adjustable outer sleeve **44** is accessible.

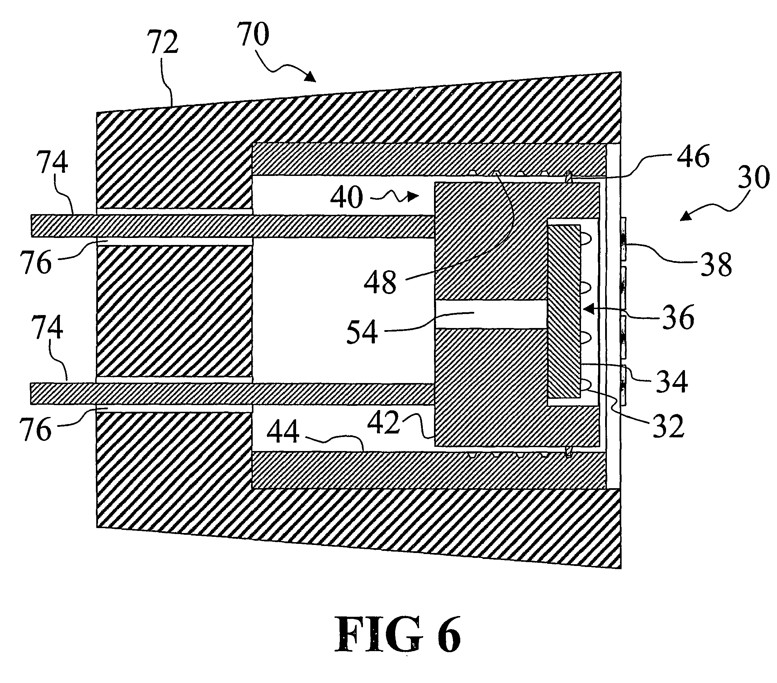

With reference to FIGURE **6,** another mounting configuration **70** for the lamp **30** of FIGURES **2** through **4** is described. In the mounting configuration **70,** the outer sleeve **44** remains fixed relative to a mounting element **72,** while movement of the inner sleeve **42** effectuates the zoom adjustment. In this case, the inner sleeve **42** is relatively inaccessible from outside the mounting configuration **70,** and so in the embodiment of FIGURE **6** one or more posts **74** are rigidly affixed to the inner sleeve **42** and pass through passthroughs **76** in the mounting element **72** to provide handles or shafts by which the inner sleeve **42** is slidably adjusted to effectuate the zoom. The mounting configuration **70** is therefore more complex versus the mounting configuration **60** of FIGURE **5.** However, the mounting configuration **70** has the advantage of fully containing the lamp **30** within the mounting element **72** so that a lighting device that employs the configuration **70** has definite and fixed outside dimensions. The one or more posts **74** are also easily adapted to connect with a motor (not shown) to effectuate a mechanized zoom adjustment.

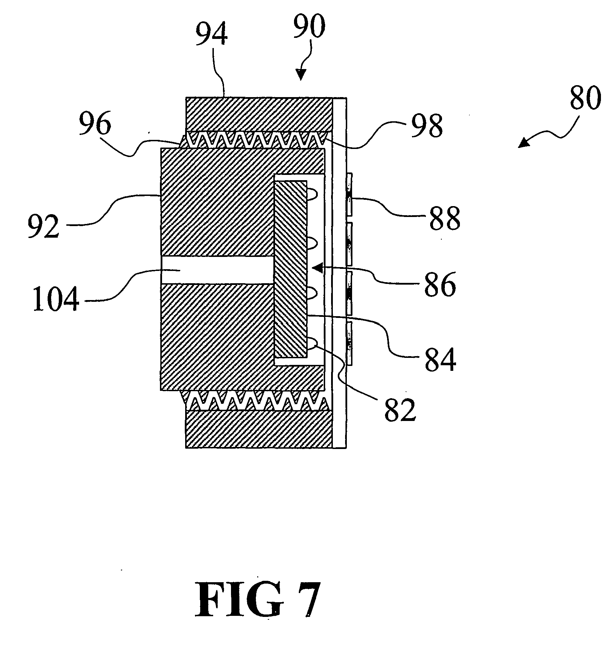

With reference to FIGURE **7,** a lamp **80** that suitably practices another embodiment of the invention in which the zoom apparatus operates on a mechanical rotation principle is described. LED's **82** are arranged on a substrate **84** forming an LED module **86.** A plurality of lenses **88,** which are preferably Fresnel lenses, are arranged in the same pattern as the LED's **82.** The rotating zoom apparatus **90** includes two threadedly interconnecting elements or sleeves **92, 94.** The LED module **86** is arranged on or in the first sleeve **92** in a fixed manner. The lenses **88** are arranged on or in the second sleeve **94,** also in a fixed manner. Thus, by relatively screwing the first and second sleeves **92, 94** into or out of each other using the cooperating threads **96, 98** disposed on the outside of the first sleeve **92** and the inside of the second sleeve **94,** respectively, the relative axial separation of the LED's **82** and the lenses 88 is adjusted. The first sleeve **92** preferably includes one or more electrical conduits **104** which are analogous to the conduit or conduits **54** of the embodiment of FIGURE **2.**

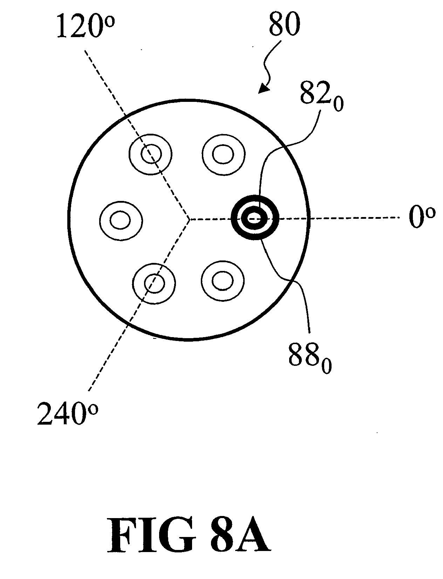

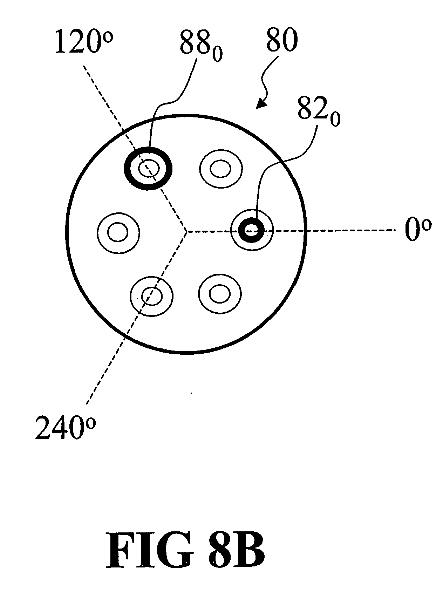

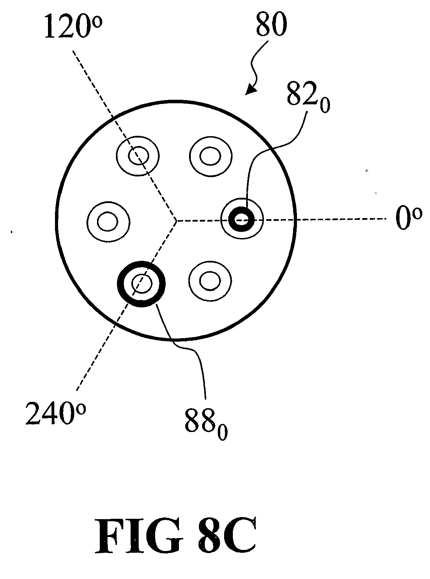

Although the LED's **82** and the lenses **88** are arranged in the same spatial pattern, it will be recognized that the rotating motion in general results in a misalignment of the LED's **82** off the optical axes of the lenses **88.** However, for certain relative rotational orientations of the sleeves **92, 94,** the two patterns align, as shown in FIGURE **8A.** The relative rotational orientation shown in FIGURE **8A** is herein designated as 0° and serves as a reference orientation. Furthermore, a specific LED **82₀,** and a specific lens **88₀,** are shown in bold in FIGURE **8A** and will be tracked during zoom adjustment using FIGURES **8B** and **8C** in the discussion which follows.

With reference to FIGURE **8B,** the reference orientation has been changed by rotating the second sleeve **94** counter-clockwise by 120°. Two changes result from the 120° rotation. First, the axial separation of the LED's **82** and the lenses **88** changes by an amount related to the spacing of the threads **96, 98** due to the screwing action. Second, the lens **88₀** is no longer axially aligned with the LED **82₀,** but rather now axially aligns with another LED as seen in FIGURE **8B.**

With reference to FIGURE **8C,** the second sleeve **94** has been rotated counter-clockwise by another 120° (240° total rotation versus FIGURE **8A**). The axial separation of the LED's **82** and the lenses **88** is again changed by an amount related to the spacing of the threads **96, 98,** and the lens **88₀** axially aligns with yet another LED as seen in FIGURE **8C.** Although not illustrated as a separate figure, it will be recognized that a third counter-clockwise rotation of 120° would bring the total rotation versus FIGURE **8A** up to 360°, i.e. one complete rotation, and would re-produce the pattern alignment shown in FIGURE **8A,** but with a change in axial spacing between the LED's **82** and the lenses **88** corresponding to the spacing of the threads **96, 98.**

In one aspect of the embodiment, the threads **96, 98** have thread joints, indented stops or another mechanism (not shown) to bias the zoom apparatus **90** into indexed positions such as those shown in FIGURES **8A, 8B,** and **8C** wherein the lens **88** pattern aligns with the LED **82** pattern. It will be recognized that if the lens **88** pattern and the LED **82** pattern each have an n-fold rotational symmetry, then separation of the rotational stop positions by integer multiples of 360°/n enables stop positions for which each LED **82** is axially aligned with one of the plurality of lenses **88.** In the exemplary embodiment shown in FIGURES **8A, 8B** and **8C,** the patterns have six-fold rotational symmetry (n=6), and the stop positions are separated by 2×(360°/n) = 120° rotations.

In another aspect of the embodiment, the rotation of the zoom apparatus 90 can also be continuous with no index biasing. In this case the frictional interaction between the threads **96, 98** should be sufficient to counteract slippage of the zoom apparatus **90.**

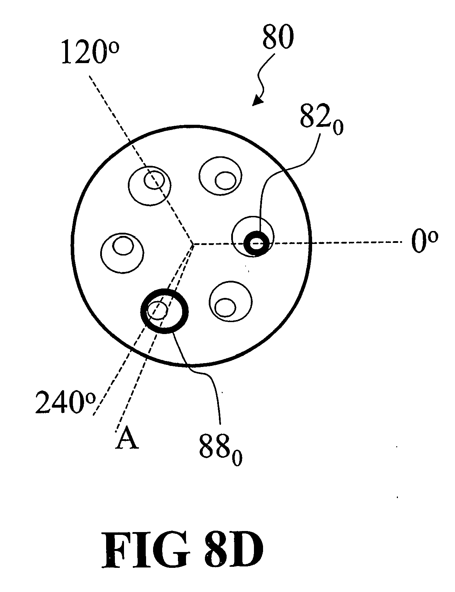

FIGURE **8D** shows a relative rotational orientation of the LED **82** pattern and the lenses **88** pattern wherein the LED's **82** are not axially aligned with the lenses **88,** but rather are relatively positioned slightly off-axis. It will be recognized that a relative pattern orientation such as that shown in FIGURE **8D** can be obtained either with or without index biasing. Such a slightly off-axis relative orientation produces defocusing which can provide further freedom for adjusting the light beam properties. In FIGURE **8D,** the second sleeve **94** has been rotated to an angle **A** relative to the reference rotational orientation of FIGURE **8A,** where the angle **A** is slightly greater than the 240° orientation that would produce pattern alignment.

In the embodiments of FIGURES **1-8D** the LEDs are shown as substantially similar, and the beam spot size or other beam characteristics is changed by relative mechanical movement of a lensing system and an LED assembly. However, the LEDs can be different. Moreover, in other embodiments, described next, beam spot size or other beam characteristics are changed by selectively energizing selected LEDs or sets of LEDs in which the LEDs or sets of LEDs are different and/or have different coupled optics.

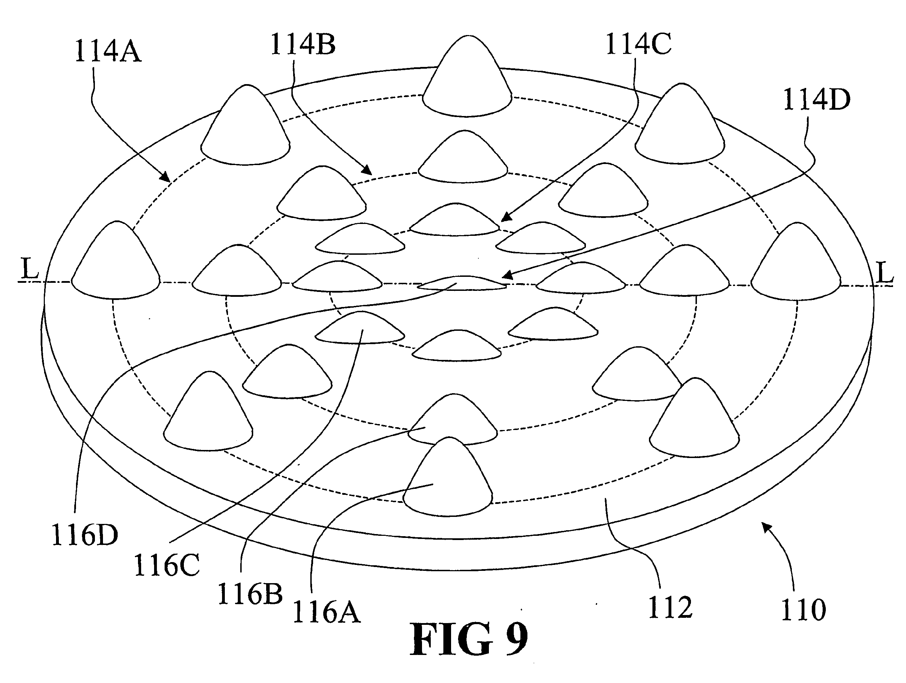

With reference to FIGURE **9,** a lamp or light source **110** includes a substrate **112** which in the embodiment of FIGURE **9** is circular in shape. Arranged on the substrate **112** are a plurality of optical sources or lighting units **114A, 114B, 114C, 114D.** Each of the lighting units or optical sources **114A, 114B, 114C, 114D** include one or more light emitting diode (LED) components. The optical source **114A** comprises eight LED components **116A.** The optical source **114B** comprises eight LED components **116B.** The optical source **114C** comprises eight LED components **116C**. The optical source **114D** comprises only a single LED component **116D**. In the embodiment of FIGURE 9, the lighting unit **114D** that includes only a single LED component **116D** is located at the center of the substrate **112.** The lighting units **114C, 114B,** and **114A** are arranged in concentric circular patterns of increasing diameter, respectively, about the lighting unit **114D**.

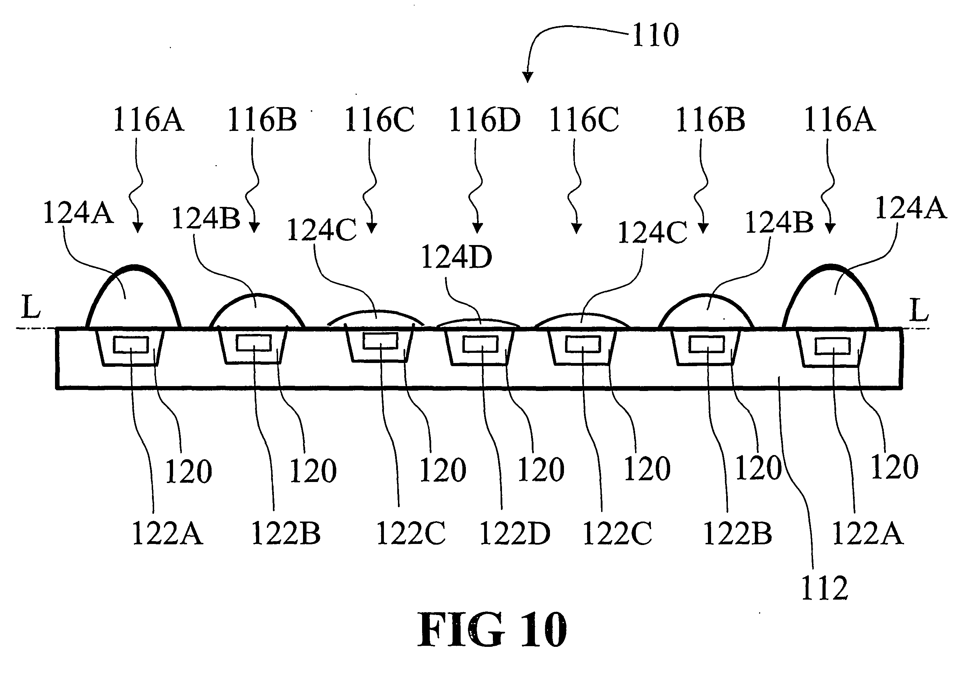

With continuing reference to FIGURE **9** and with further reference now to FIGURE **10,** an embodiment of the LED components **116A, 116B, 116C, 116D** is described. FIGURE **10** shows a cross-sectional view of the lamp or light source **110** taken perpendicular to the substrate **112** along the Line **L-L** shown in FIGURE **9.** A plurality of wells **120** are formed in the substrate **112** for receiving LED elements **122A, 122B, 122C, 122D** that correspond to the LED components **116A, 116B, 116C, 116D,** respectively. The substrate **110** is manufactured using a thermal heat sinking material such as a copper plate. Mounting of the LED elements and electrical contacting thereof are steps that are well known to the art and need not be described herein for an enabling disclosure.

It will be appreciated that the LED elements **122A, 122B, 122C, 122D** need not be identical to one another, but can instead include LED elements emitting light at different colors or with different spectral distributions, different optical intensities, and the like. The LED elements **122A, 122B, 122C, 122D** can be manufactured from different materials, e.g. LED element **122A** can be a group III-nitride LED element emitting blue light, whereas LED element **122B** can be a group III-phosphide LED element emitting red light. Furthermore, in the case of a plurality of LED elements comprising a lighting unit or optical source, e.g. the optical source **114A,** every LED element of the plurality need not be identical. For simplicity, however, FIGURE 2 shows all the LED elements **122A, 122B, 122C, 122D** as being essentially identical.

The LED components **116A, 116B, 116C, 116D** also include optical elements such as lenses **124A, 124B, 124C, 124D.** In order to effectuate different angular distributions or spatial patterns for the light emitted by the lighting units **114A, 114B, 114C, 114D,** the corresponding optical elements or lenses **124A, 124B, 124C, 124D** each have different optical prescriptions. The lenses **124A, 124B, 124C, 124D** can be discrete elements that are mounted above the wells 120. Alternatively, the optical elements **124A, 124B, 124C, 124D** can be formed by controlled shaping or molding of an epoxy or resin encapsulant that is used to hermetically seal the LED elements **122A, 122B, 122C, 122D.** In the illustrated embodiment of FIGURES **9** and **10,** the different optical prescriptions are effectuated by different radii of the conic of the lenses or epoxy "bumps" **124A, 124B, 124C, 124D.** Of course, other approaches for effectuating a pre-selected optical prescription can also be employed, such as by using different materials having different refractive indexes for each type of optical element **124A, 124B, 124C, 124D.** It will also be appreciated that the optical elements **124A, 124B, 124C, 124D** can, in addition to effectuating pre-selected optical prescriptions, also alter the light emitted by the optical sources **114A, 114B, 114C, 114D** in other ways. For example, the optical elements or lenses **124A, 124B, 124C, 124D** can be selectively tinted to alter the color or spectral distribution of the light passing therethrough in a pre-selected manner.

The embodiment illustrated in FIGURE **10** is exemplary only. Other configurations for the LED components **116A, 116B, 116C, 116D** and for the substrate **112** are also contemplated. For example, the substrate **112** can be a printed circuit board (PC board) with the LED elements **122A, 122B, 122C, 122D** bonded directly thereto. The wells **120** would typically be omitted in this alternate embodiment.

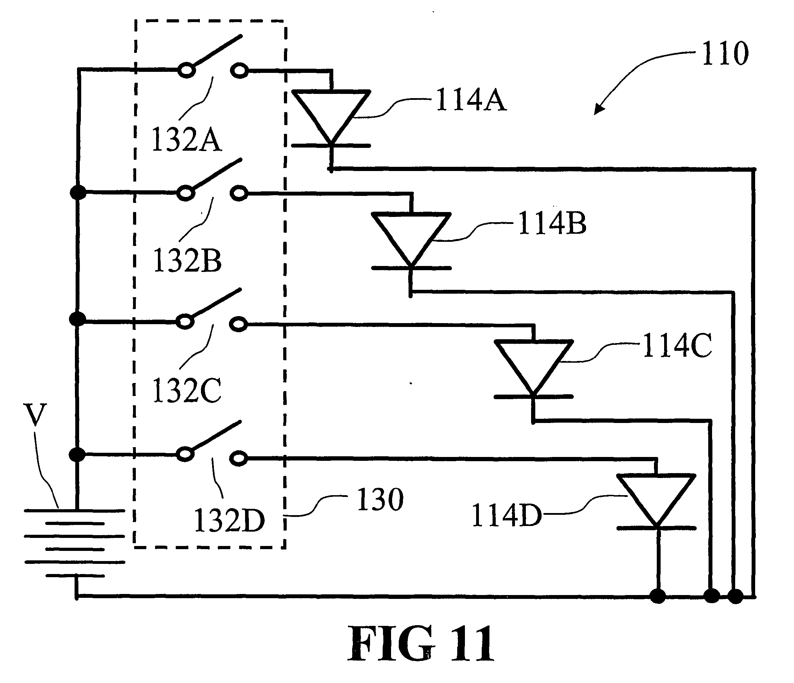

With reference now to FIGURE **11,** the electrical configuration of the embodiment of FIGURES **9** and **10** is described. An associated voltage source V provides electrical power for the light source or lamp **110** that in the embodiment of FIGURES **9** and **11** includes four optical sources or lighting units **114A, 114B, 114C, 114D.** The lamp **110** further includes a control unit **130** that has four switches **132A, 132B, 132C, 132D** for selectively applying electrical power to the corresponding lighting units **114A, 114B, 114C, 114D.** The switches **132A, 132B, 132C, 132D** can be manual switches, electronically controlled switches, or other switch types. The control unit **130** optionally includes additional elements (not shown) such as a computer interface or components for conditioning the power applied to the lighting units. In the illustrated electrical configuration of FIGURE **11,** the four lighting units **114A, 114B, 114C, 114D** are independently selectable, and any combination of the lighting units **114A, 114B, 114C, 114D** can be selectively powered at any given time. Each of the lighting units **114A, 114B, 114C, 114D** has a different optical prescription, obtained in the embodiment of FIGURES **9** and **10** by using different conic radii for the lenses **124A, 124B, 124C, 124D.** Thus, by operating only a selected one of the four lighting units **114A, 114B, 114C, 114D** four different angular distributions or spatial patterns of emitted light can be selectively obtained. By operating a selected sub-set of the plurality of optical sources **114A, 114B, 114C, 114D,** complex combinations of the spatial light distributions of the individual optical sources **114A, 114B, 114C, 114D** can be obtained. In a limiting operational case, all four optical sources **114A, 114B, 114C, 114D** can be operated simultaneously using the electrical configuration shown in FIGURE **11.**

The electrical configuration of FIGURE **11** is exemplary only, and a number of variations thereof are contemplated. As noted previously, the LED elements **122A, 122B, 122C, 122D** can be of different types, e.g. GaN LED elements, InGaAlP LED elements, and so forth. In cases where the LED elements comprising the lighting units differ, the control unit **130** optionally includes voltage dividers (not shown) or other power conditioning components that control the power applied to each optical source **114A, 114B, 114C, 114D.** Furthermore, as noted previously a given optical source, e.g. optical source **114A,** can include LED elements of different types. In this case, the optical source **114A** would itself include one or more electrical components (not shown) such as voltage dividers that condition the voltage applied to each LED element within the optical source **114A.** In yet another variant, the control unit **130** includes a rheostat, variable voltage divider, or other electrical component (not shown) that enables variable power application to the lamp **110** as a whole or to one or more of the individual lighting units **114A, 114B, 114C, 114D** that are included in the lamp **110.** Such an arrangement advantageously enables the user to control the optical intensity as well as the spatial distribution of the light output.

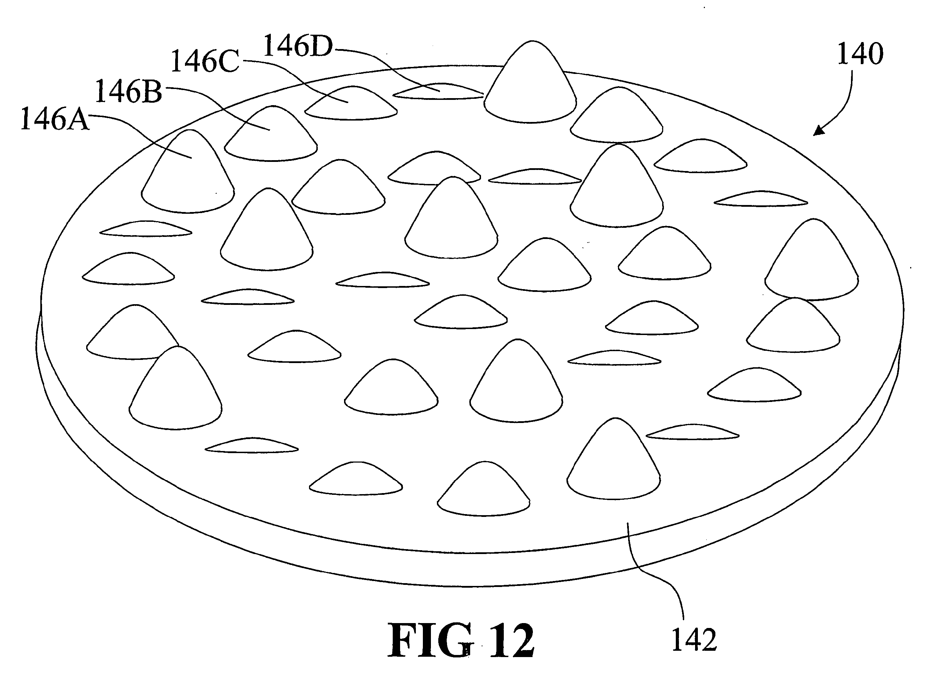

With reference now to FIGURE **12,** a second embodiment **140** of the invention is described. A circular substrate **142** has four lighting units arranged thereon. Each lighting unit includes a plurality of essentially identical LED components. The LED components of each lighting unit differ from the LED components of the other three lighting units. Hence, there are four LED component types **146A, 146B, 146C, 146D** arranged on the substrate **142,** corresponding to the four lighting units. Unlike the embodiment of FIGURE **9,** the embodiment of FIGURE **12** has an equal number of LED components of each type, and the distribution of the LED component types **146A, 146B, 146C, 146D** across the substrate **142** is essentially uniform. Although the spatial distribution of the LED component types is uniform, the tamp **140** nonetheless is capable of producing light having at least four selectable spatial or angular distributions because each of the four LED component types **146A, 146B, 146C, 146D** has a different optical prescription, as indicated by the different conic radii of the four LED component types **146A, 146B, 146C, 146D.** Thus, the corresponding four lighting units each produce light having a different spatial or angular light distribution.

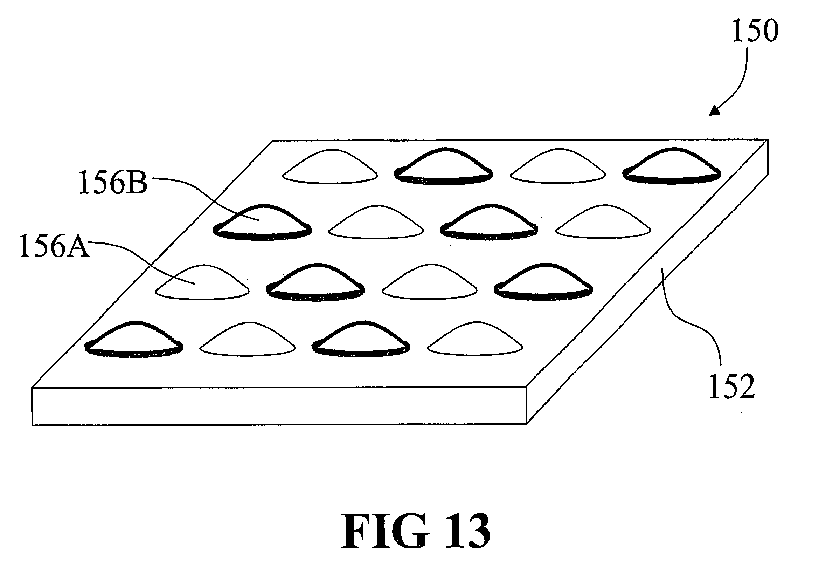

With reference now to FIGURE **13,** a third embodiment **150** of the invention is described. A rectangular substrate **152** has two lighting units corresponding to LED components of types **156A** and **156B,** respectively. The LED component types **156A, 156B** have optical elements with essentially similar conic radii. However, different optical prescriptions are obtained by using materials having different refractive indexes for the optical elements of each component type **156A, 156B.** Hence, the embodiment of FIGURE **13** has a first angular or spatial light distribution obtained when the first optical source comprising the LED components of type **156A** are activated; and a second angular or spatial light distribution obtained when the second optical source comprising the LED components of type **156B** are activated. Optionally, a third angular or spatial light distribution can be obtained by activating both the first and the second optical sources together, the third angular or spatial distribution operatively combining the first and the second light output distributions.

Those skilled in the art will appreciate that embodiments of the type **110, 140, 150** in which beam spot size or other beam characteristics are changed by selectively energizing selected LEDs or sets of LEDs are readily combined with the embodiments of the type **10, 30, 80** in which the beam characteristics are varied by relative mechanical movement of a lensing system and an LED assembly.

For example, the light source **110** of FIGURE **9** has an eight-fold rotational symmetry that is particularly suitable for use in a rotationally adjustable spot module lamp similar to the lamp **80** of FIGURE **7.** The light source **110** suitably replaces the LED module **86** of the lamp **80.** The lenses **124** in one contemplated embodiment are located on the second sleeve **94,** that is the lenses **124** replace the lenses **88** of the spot module **80.** In another contemplated embodiment the lenses **124** are affixed to the light source **110** as shown in FIGURE **9,** and the lenses **88** are separate lenses that cooperate with the lenses **124** to provide the selected optical focusing. The light sources **140, 150** are less suitable for a rotationally adjustable spot module lamp, since these sources **140, 150** would require a 360° rotation. However, any of the light sources **110, 140, 150** are suitably used in conjunction with a slidably adjustable spot module lamp similar to the lamp **30** of FIGURES **2-4.**

The invention has been described with reference to the preferred embodiments. Obviously, modifications and alterations will occur to others upon reading and understanding the preceding detailed description. It is intended that the invention be construed as including all such modifications and alterations insofar as they come within the scope of the appended claims or the equivalents thereof.

## Claims

1. A spot module having a selectable light output, the spot module including:
a substrate **(14, 34, 112, 142, 152)**;
a plurality of optical sources **(114A, 114B, 114C, 114D)** arranged on the substrate **(14, 34, 112, 142, 152),** each optical source **(114A, 114B, 114C, 114D)** including:
at least one light emitting diode **(116A, 116B, 116C, 116D, 146A, 146B, 146C, 146D, 156A, 156B)**, and
at least one optical element **(18, 38)** in operative communication with the at least one light emitting diode **(116A, 116B, 116C, 116D, 146A, 146B, 146C, 146D, 166A, 156B);** and a zoom apparatus supporting the optical elements **(18, 38)** of the optical sources **(114A, 114B, 114C, 114D) characterized in that** the zoom apparatus is comprising inner and outer slidably interconnected sleeves **(42, 44),** one of the sleeves **(42, 44)** being connected with the at least one light emitting diode **(116A, 116B, 116C, 116D, 146A, 146B, 146C, 146D, 156A, 156B)** and the other one of the sleeves **(42, 44)** being connected with the at least one optical element **(18, 38),** relative sliding of the inner and outer slidably interconnected sleeves **(42, 44)** adjusting an axial separation between the at least one light emitting diode **(116A, 116B, 116C, 116D, 146A, 146B, 146C, 146D, 156A, 156B)** of each optical source **(114A, 114B, 114C, 114D)** and its corresponding at least one optical element **(18, 38)**.

2. The spot module as set forth in claim 1, wherein each of the plurality of optical sources **(114A, 114B, 114C, 114D)** produces light having selected output characteristics, the selected output characteristics differing for each of the optical light sources **(114A, 114B, 114C, 114D),** the spot module further including:
a control unit **(130)** that selectively operates a selected one or more of the optical sources **(114A, 114B, 114C, 114D)** to produce light having selected light output characteristics.

3. The spot module as set forth in claim 2, wherein the selective operation of the plurality of optical sources **(114A, 114B, 114C, 114D)** includes at least one of:
selectively operating one of the plurality of optical sources **(114A, 114B, 114C, 114D);**
selectively operating a sub-set of the plurality of optical sources **(114A, 114B, 114C, 114D);** and
selectively operating all of the plurality of optical sources **(114A, 114B, 114C, 114D).**

4. The spot module as set forth in claim 1, wherein the at least one optical element **(18, 38)** includes a lens **(18, 38)** corresponding to each light emitting diode **(116A, 116B, 116C, 116D, 146A, 146B, 146C, 146D, 156A, 156B),** the lens receiving and focusing light from the light emitting diode **(116A, 116B, 116C, 116D, 146A, 146B, 146C, 146D, 156A, 156B).**

5. The spot module as set forth in claim 4, wherein each light emitting diode further includes:
an epoxy or resin encapsulant **(124A, 124B, 124C, 124D)** that hermetically seals the light emitting diode, the epoxy or resin encapsulant **(124A, 124B, 124C, 124D)** providing light refraction that cooperates with the lens **(18, 38)** to focus the light.

6. A lamp including:
an LED module **(86)** including a plurality of LEDs **(82);**
an optical system comprising a plurality of lenses **(88)** in optical communication with the LED module **(86)** along an optical axis between the lenses and the LEDs; and
a zoom apparatus **(90)** that selectively adjusts the relative axial separation of the optical system and the LED module **(86)**, **characterized in that** the zoom apparatus is including:
a first sleeve **(92)** having the LED module **(86)** arranged thereon, the first sleeve (90) further having a first threading **(96)** arranged thereon,
a second sleeve **(94)** having a second threading **(98)** arranged thereon that is adapted to cooperate with the first threading **(96)** such that the first sleeve **(92)** and the second sleeve **(94)** are relatively movable in a screwing fashion, the second sleeve **(94)** further having the optical system arranged thereon, and
an index system that relatively biases the first sleeve **(92)** and the second sleeve **(94)** into one or more selectable relative rotational orientations.

7. The lamp as set forth in claim 6, wherein the at least one lens **(88)** includes:
a plurality of Fresnel lens arranged in a second pattern that corresponds with the first pattern.

8. The lamp as set forth in claim 6, wherein the optical system includes:
a plurality of lenses **(88)** wherein each lens is axially aligned with an LED **(82)** and optically communicates with said LED **(12, 32, 82)** with the first sleeve **(92)** and the second sleeve **(94)** in one of the selectable relative rotational orientations.

9. The lamp as set forth in claim 6, wherein the plurality of LEDs **(12, 32, 82)** of the LED module **(16, 36, 86)** include:
a first LED lighting unit **(114A)** including a plurality of first LEDs **(116A, 146A, 156A)** that produce light having first characteristics; and
a second LED lighting unit **(114B)** including a plurality of second LEDs **(116B, 146B, 156B)** that produce light having second characteristics which are different from the first characteristics;
wherein the first and second LED lighting units **(114A, 114B)** are selectively operated to produce light output with a selected one of the first and second characteristics.

10. The spot module as set forth in claim 1 further including:
a mechanical interlock **(50, 52)** between the inner and outer sleeves **(42, 44)** that prevents relative rotation therebetween.

11. The spot module as set forth in claim 10, wherein the mechanical interlock **(50, 52)** includes:
a protrusion **(50)** on one of the inner and the outer sleeves **(42, 44),** the protrusion (50) being aligned parrallel to the optical axis; and
a groove **(52)** on one of the inner and the outer sleeves **(42, 44)** that receives the protrusion **(50)** to prevent relative rotation of the inner and outer sleeves **(42, 44).**

12. The spot module as set forth in claim 1, further including:
a stop **(46)** that relatively biases the inner and outer sleeves **(42, 44)** into one or more selectably relative axial stop positions **(48).**

13. The lamp as set forth in claim 6, wherein the LED module **(16)** further including:
a heat sink **(24)** thermally connected with the substrate **(14)** for cooling the LED module **(16)**.

## Patentansprüche

1. Spotmodul mit einer auswählbaren Lichtausgabe, wobei das Spotmodul aufweist:
ein Substrat (14, 34, 112, 142, 152),
eine Mehrzahl von optischen Quellen (114A, 114B, 114C, 114D), die auf dem Substrat (14, 34, 112, 142, 152) angeordnet sind, wobei jede optische Quelle (114A, 114B, 114C, 114D) beinhaltet:
zumindest eine lichtemittierende Diode (116A, 116B, 116C, 116D, 146A, 146B, 146C, 146D, 156A, 156B) und
zumindest ein optisches Element (18, 38), das in Funktionsverbindung mit der zumindest einen lichtemittierenden Diode (116A, 116B, 116C, 116D, 146A, 146B, 146C, 146D, 156A, 156B) steht, und eine Zoomvorrichtung, die die optischen Elemente (18, 38) der optischen Quellen (114A, 114B, 114C, 114D) trägt, **dadurch gekennzeichnet, daß** die Zoomvorrichtung aufweist eine innere und eine äußere miteinander verbundene verschiebbare Hülse (42, 44), wobei eine der Hülsen (42, 44) mit der zumindest einen lichtemittierenden Diode (116A, 116B, 116C, 116D, 146A, 146B, 146C, 146D, 156A, 156B) verbunden ist und die andere der Hülsen (42, 44) mit dem zumindest einen optischen Element (18, 38) verbunden ist, wobei das relative Verschieben der inneren und äußeren verschiebbar miteinander verbundenen Hülsen (42, 44) einen axialen Abstand zwischen der zumindest einen lichtemittierenden Diode (116A, 116B, 116C, 116D, 146A, 146B, 146C, 146D, 156A, 156B) jeder optischen Quelle (114A, 114B, 114C, 114D) und ihrem entsprechenden zumindest einen optischen Element (18, 38) einstellt.

2. Spotmodul nach Anspruch 1, bei dem jede der Mehrzahl von optischen Quellen (114A, 114B, 114C, 114D) Licht erzeugt mit einer ausgewählten Ausgangscharakteristik, wobei die ausgewählte Ausgangscharakteristik sich für jede der optischen Lichtquellen (114A, 114B, 114C, 114D) unterscheidet, wobei das Spotmodul weiterhin beinhaltet:
eine Steuereinheit (130), die selektiv oder mehrere der optischen Quellen (114A, 114B, 114C, 114D) betreibt, um Licht mit ausgewählten Lichtausgangscharakteristiken zu erzeugen.

3. Spotmodul nach Anspruch 2, bei dem der selektive Betrieb der Mehrzahl von optischen Quellen (114A, 114B, 114C, 114D) zumindest eines beinhaltet von:
selektives Betreiben von einer der Mehrzahl von optischen Quellen (114A, 114B, 114C, 114D),
selektives Betreiben einer Untergruppe der Mehrzahl von optischen Quellen (114A, 114B, 114C, 114D),
selektives Betreiben aller der Mehrzahl von optischen Quellen (114A, 114B, 114C, 114D).

4. Spotmodul nach Anspruch 1, bei dem das zumindest eine optische Element (18, 38) eine Linse (18, 38) beinhaltet, wobei die Linse zu jeder lichtemittierenden Diode (116A, 116B, 116C, 116D, 146A, 146B, 146C, 146D, 156A, 156B) korrespondiert, wobei die Linse Licht von der lichtemittierenden Diode (116A, 116B, 116C, 116D, 146A, 146B, 146C, 146D, 156A, 156B) empfängt und fokussiert.

5. Spotmodul nach Anspruch 4, bei dem jede lichtemittierende Diode weiterhin beinhaltet:
eine Epoxid- oder Harzverkapselung (124A, 124B, 124C, 124D), die hermetisch die lichtemittierende Diode abdichtet, wobei die Epoxid- oder Harzverkapselung (124A, 124B, 124C, 124D) eine Lichtbrechung bereitstellt, die mit der Linse (18, 38) zusammenarbeitet, um das Licht zu fokussieren.

6. Lampe, die beinhaltet:
ein LED-Modul (86) einschließlich einer Mehrzahl von LEDs (82),
ein optisches System, das eine Mehrzahl von Linsen (88) in optischer Verbindung mit dem LED-Modul (86) entlang einer optischen Achse zwischen den Linsen und den LEDs aufweist, und
eine Zoomvorrichtung (90), die selektiv den relativen axialen Abstand des optischen Systems und des LED-Moduls (86) einstellt, **dadurch gekennzeichnet, daß** die Zoomvorrichtung aufweist:
eine erste Hülse (92), auf der das LED-Modul (86) angeordnet ist, wobei die erste Hülse (90) weiterhin ein erstes Gewinde (96) darauf aufweist,
eine zweite Hülse (94) mit einem zweiten Gewinde (98), das hierauf angeordnet ist und derart angepaßt ist, daß es mit dem ersten Gewinde (96) zusammenarbeitet, so daß die erste Hülse (92) und die zweite Hülse (94) relativ zueinander in einer Schraubweise bewegbar sind, wobei die zweite Hülse (94) weiterhin das optische System behält, um
ein Indexsystem, das die erste Hülse (92) und die zweite Hülse (94) in eine oder mehrere auswählbare relative Drehorientierungen vorspannt.

7. Lampe nach Anspruch 6, wobei die zumindest eine Linse (88) beinhaltet:
eine Mehrzahl von Fresnel-Linsen, die in einem zweiten Muster angeordnet sind, das zu dem ersten Muster korrespondiert.

8. Lampe nach Anspruch 6, bei der das optische System beinhaltet:
eine Mehrzahl von Linsen (88), wobei jede Linse axial mit einer LED (82) ausgerichtet ist und optisch mit der LED (12, 32, 82), mit der ersten Hülse (92) und der zweiten Hülse (94) in einer der auswählbaren relativen Drehorientierungen kommuniziert.

9. Lampe nach Anspruch 6, bei der die Mehrzahl von LEDs (12, 32, 82) des LED-Moduls (16, 36, 86) beinhaltet:
eine erste LED-Belichtungseinheit (114A), einschließlich einer Mehrzahl von ersten LEDs (116A, 146A, 156A), die Licht mit einer ersten Charakteristik erzeugen, und
eine zweite LED-Belichtungseinheit (114B), die eine Mehrzahl von zweiten LEDs (116B, 146B, 156B) beinhaltet, die Licht mit einer zweiten Charakteristik erzeugt, die sich von der ersten Charakteristik unterscheidet,
wobei die erste und zweite LED-Belichtungseinheit (114A, 114B) selektiv betreibbar sind, um eine Lichtausgabe zu erzeugen mit der ausgewählten ersten oder zweiten Charakteristik.

10. Spotmodul nach Anspruch 1, das weiterhin beinhaltet:
eine mechanische Blockierung (50, 52) zwischen der inneren und äußeren Hülse (42, 44), die eine relative Drehung zwischen den Hülsen verhindert.

11. Spotmodul nach Anspruch 10, bei dem die mechanische Blockierung (50, 52) beinhaltet:
einen Vorsprung (50) auf der inneren oder der äußeren Hülse (42, 44), wobei der Vorsprung (50) parallel mit der optischen Achse ausgerichtet ist, und
eine Nut bzw. Rille (52) in der inneren oder äußeren Hülse (42, 44), die den Vorsprung (50) aufnimmt, um die relative Drehbewegung der inneren Hülse gegenüber der äußeren Hülse (42, 44) zu verhindern.

12. Spotmodul nach Anspruch 1, der weiterhin beinhaltet:
einen Anschlag (46), der die innere und äußere Hülse (42, 44) in eine oder mehrere auswählbare relative axiale Anschlagpositionen (48) vorspannt.

13. Lampe nach Anspruch 6, bei der das LED-Modul (16) weiterhin beinhaltet:
eine Wärmesenke (24), die thermisch mit dem Substrat (14) verbunden ist, für das Kühlen des LED-Moduls (16).

## Revendications

1. Module formant projecteur directif ayant une sortie sélectionnable de lumière, le module formant projecteur directif comprenant :
un substrat (14, 34, 112, 142, 152);
une pluralité de sources optiques (114A, 114B, 114C, 114D) disposées sur le substrat (14, 34, 112, 142, 152), chaque source optique (114A, 114B, 114C, 114D) comprenant :
au moins une diode luminescente (116A, 116B, 116C, 116D, 146A, 146B, 146C, 146D, 156A, 156B), et
au moins un élément optique (18, 38) communiquant en fonctionnement avec ladite au moins une diode luminescente (116A, 116B, 116C, 116D, 146A, 146B, 146C, 146D, 156A, 156B) ; et un appareil formant zoom portant les éléments optiques (18, 38) des sources optiques (114A, 114B, 114C, 114D), **caractérisé en ce que** l'appareil formant zoom se compose de manchons (42, 44) intérieur et extérieur reliés l'un à l'autre de manière coulissante, l'un des manchons (42, 44) étant relié à ladite au moins une diode luminescente (116A, 116B, 116C, 116D, 146A, 146B, 146C, 146D, 156A, 156B) et l'autre des manchons (42, 44) étant relié audit au moins un élément optique (18, 38), le coulissement relatif des manchons (42, 44) intérieur et extérieur reliés l'un à l'autre de manière coulissante réglant une séparation axiale entre ladite au moins une diode luminescente (116A, 116B, 116C, 116D, 146A, 146B, 146C, 146D, 156A, 156B) de chaque source optique (114A, 114B, 114C, 114D) et ledit au moins un élément optique (18, 38) qui lui correspond.

2. Module formant projecteur directif selon la revendication 1, dans lequel chaque source de la pluralité de sources optiques (114A, 114B, 114C, 114D) produit une lumière ayant des caractéristiques sélectionnées de sortie, les caractéristiques sélectionnées de sortie étant différentes pour chacune des sources optiques (114A, 114B, 114C, 114D) de lumière, et le module formant projecteur directif comprenant en outre :
une unité de commande (130) qui fait fonctionner, de façon sélective, une ou plusieurs sources sélectionnées des sources optiques (114A, 114B, 114C, 114D) afin de produire une lumière ayant des caractéristiques sélectionnées de sortie de lumière.

3. Module formant projecteur directif selon la revendication 2, dans lequel le fonctionnement sélectif de la pluralité de sources optiques (114A, 114B, 114C, 114D) comprend au moins l'une de :
la mise en fonction sélective d'une source de la pluralité de sources optiques (114A, 114B, 114C, 114D);
la mise en fonction sélective d'un sous-ensemble de la pluralité de sources optiques (114A, 114B, 114C, 114D) ; et
la mise en fonction sélective de toutes les sources de la pluralité de sources optiques (114A, 114B, 114C, 114D).

4. Module formant projecteur directif selon la revendication 1, dans lequel ledit au moins un élément optique (18, 38) comprend une lentille (18, 38) correspondant à chaque diode luminescente (116A, 116B, 116C, 116D, 146A, 146B, 146C, 146D, 156A, 156B), la lentille recevant et focalisant la lumière provenant de la diode luminescente (116A, 116B, 116C, 116D, 146A, 146B, 146C, 146D, 156A, 156B).

5. Module formant projecteur directif selon la revendication 4, dans lequel chaque diode luminescente comprend en outre :
un élément d'encapsulation en époxy ou en résine (124A, 124B, 124C, 124D) qui loge hermétiquement la diode luminescente, l'élément d'encapsulation en époxy ou en résine (124A, 124B, 124C, 124D) assurant une réfraction de lumière, pour une coopération avec la lentille (18, 38) afin de focaliser la lumière.

6. Lampe, comprenant :
un module à diodes luminescentes (LED) (86) comprenant une pluralité de LED (82) ;
un système optique comprenant une pluralité de lentilles (88) en communication optique avec le module à LED (86) suivant un axe optique entre les lentilles et les LED ; et
un appareil formant zoom (90) qui ajuste sélectivement la séparation axiale relative du système optique et du module à LED (86), **caractérisée en ce que** l'appareil formant zoom comprend :
un premier manchon (92) sur lequel est disposé le module à LED (86), le premier manchon (90) comportant en outre un premier filetage (96) ménagé sur lui,
un second manchon (94) sur lequel est disposé un second filetage (98) propre à coopérer avec le premier filetage (96) de telle manière que le premier manchon (92) et le second manchon (94) soient relativement mobiles à la manière d'un vissage, le second manchon (94) comportant en outre le système optique installé sur lui, et
un système de curseur, qui sollicite relativement le premier manchon (92) et le second manchon (94) pour qu'ils prennent une ou plusieurs orientations relatives en rotation, sélectionnables.

7. Lampe selon la revendication 6, dans laquelle ladite au moins une lentille (88) comprend :
une pluralité de lentilles de Fresnel, disposées selon un second motif qui correspond au premier motif.

8. Lampe selon la revendication 6, dans laquelle le système optique comprend :
une pluralité de lentilles (88), dans laquelle chaque lentille est en alignement axial avec une LED (82) et communique optiquement avec ladite LED (12, 32, 82) par le premier manchon (92) et le second manchon (94) dans l'une des orientations relatives en rotation, sélectionnables.

9. Lampe selon la revendication 6, dans laquelle la pluralité de LED (12, 32, 82) du module à LED (16, 36, 86) comprend :
une première unité d'éclairage à LED (114A) comprenant une pluralité de premières LED (116A, 146A, 156A) qui produisent une lumière ayant des premières caractéristiques; et
une seconde unité d'éclairage à LED (114B) comprenant une pluralité de secondes LED (116B, 146B, 156B) qui produisent une lumière ayant des secondes caractéristiques, différentes des premières caractéristiques ;
dans laquelle les première et seconde unités d'éclairage à LED (114A, 114B) sont sélectivement mises en fonction pour produire une sortie de lumière ayant une caractéristique sélectionnée, parmi les premières et secondes caractéristiques.

10. Module formant projecteur directif selon la revendication 1, comprenant en outre :
un dispositif de verrouillage mécanique (50, 52) entre les manchons intérieur et extérieur (42, 44) afin d'empêcher une rotation relative entre eux.

11. Module formant projecteur directif selon la revendication 10, dans lequel le dispositif de verrouillage mécanique (50, 52) comprend :
une protubérance (50) sur l'un des manchons intérieur et extérieur (42, 44), la protubérance (50) étant alignée parallèlement à l'axe optique ; et
une rainure (52) sur l'un des manchons intérieur et extérieur (42, 44), pour recevoir la protubérance (50) afin d'empêcher une rotation relative des manchons intérieur et extérieur (42, 44).

12. Module formant projecteur directif selon la revendication 1, comprenant en outre :
un taquet (46) qui sollicite relativement les manchons intérieur et extérieur (42, 44) vers une ou plusieurs positions relatives d'arrêt axial (48) sélectionnables.

13. Lampe selon la revendication 6, dans laquelle le module à LED (16) comprend en outre :
un puits de chaleur (24) thermiquement relié au substrat (14) pour le refroidissement du module à LED (16).
